# FASCICULE DE BREVET EUROPEEN

(11) **EP 2 299 493 B1**
(45) Date de publication et mention de la délivrance du brevet: **19.08.2015**
(21) Numéro de dépôt: 10176405.8
(22) Date de dépôt: 13.09.2010
(51) Int. Cl.: H01L 29/775, H01L 29/786, H01L 21/335

(54) **Fabrication de nano-fils de silicium et germanium intégrés sur un substrat**
Herstellung von Silizium und Germanium Nanodrähten integrierte auf einem Substrat
Fabrication of silicon and germanium nanowires integrated on a substrate

(30) Priorité: 18.09.2009 FR 0956427
(43) Date de publication de la demande: 23.03.2011
(73) Titulaire: Commissariat à l'Énergie Atomique et aux Énergies Alternatives, 75015 Paris (FR)
(72) Inventeur: Saracco, Emeline, 38000, Grenoble (FR); Damlencourt, Jean-François, 38190, Laval (FR); Heitzmann, Michel, 38920, Crolles (FR)
(74) Mandataire: Ilgart, Jean-Christophe

(56) Documents cités:
- WO-A1-2008/069765
- US-A1- 2007 029 586
- US-A1- 2008 017 934

## Description

### DOMAINE TECHNIQUE

L'invention concerne le domaine de la micro-électronique et des micro-technologies et/ou nano-technologies.

Elle a pour but de présenter un dispositif micro-électronique doté de nano-fils semi-conducteurs à base d'un matériau semi-conducteur et de nano-fils semi-conducteurs à base d'un autre matériau semi-conducteur, sur un même substrat.

La présente invention s'applique également à la réalisation d'un dispositif comprenant un ou plusieurs transistors doté(s) chacun d'un ou plusieurs nano-fils semi-conducteurs à base d'un matériau semi-conducteur et comprenant en outre un ou plusieurs transistors doté(s) chacun d'un ou d'un ou plusieurs nano-fils semi-conducteurs à base d'un autre matériau semi-conducteur.

### ART ANTERIEUR

Il est connu de réaliser des transistors dotés d'une structure multi-canaux formée d'une pluralité de nano-fils semi-conducteurs, ayant une dimension critique ou un diamètre compris entre 5 et 50 nanomètres.

Les dispositifs à transistors dotés à la fois de transistors NMOS et de transistors PMOS ont des performances électriques améliorées lorsque la structure de canal des transistors NMOS est à base de Si tandis que celle des transistors PMOS est à base de SiGe.

Il est connu par ailleurs de réaliser des nano-fils semi-conducteurs par croissance, et/ou par oxydation de barreaux semi-conducteurs parallélépipédiques.

Le document FR 2 905 197 document divulgue quant à lui un procédé de réalisation de nano-fils à base de Si_{y}Ge_{1-y}.

Le document WO 2008/069 765 divulgue un procédé de fabrication d'une structure de nanofils en silicium-germanium.

Il se pose le problème de réaliser un dispositif doté de nano-fils semi-conducteurs à base de matériaux semi-conducteurs différents sur un même substrat.

### EXPOSÉ DE L'INVENTION

L'invention concerne la réalisation d'un dispositif microélectronique comprenant, sur un même substrat, un ou plusieurs nano-fil(s) à base d'un matériau semi-conducteur donné, et un ou plusieurs nano-fil(s) à base d'un autre matériau semi-conducteur.

Elle prévoit la mise en oeuvre d'un procédé comprenant des étapes de :
a) formation sur un substrat, d'au moins un premier bloc semi-conducteur et d'au moins un deuxième bloc semi-conducteur distinct du premier bloc, le premier et le deuxième bloc comprenant chacun un ou plusieurs barreaux à base d'un premier matériau semi-conducteur et un ou plusieurs autres barreaux à base d'un deuxième matériau semi-conducteur, lesdits barreaux et autres barreaux s'étendant suivant une même direction qui est parallèle au substrat,
b) retrait dans ledit deuxième bloc semi-conducteur du ou des barreaux à base du deuxième matériau semi-conducteur, tandis que les barreaux du premier bloc sont protégés,
c) oxydation du ou des barreaux à base du premier semi-conducteur et appartenant au deuxième bloc de manière à former un ou plusieurs nano-fils entourés d'une épaisseur d'oxyde du premier matériau semi-conducteur, tandis que les barreaux du premier bloc sont protégés par un masquage à oxydation,
d) retrait du masquage à oxydation,
e) retrait du ou des barreaux à base du premier matériau semi-conducteur dans le premier bloc tandis que les nano-fils à base du premier matériau semi-conducteur sont protégés,
f) oxydation des barreaux à base du deuxième matériau semi-conducteur de manière à former un ou plusieurs autre (s) nano-fil (s) .

Le deuxième matériau semi-conducteur est un matériau dont l'oxydation est plus rapide que celle du premier matériau semi-conducteur.

L'étape c) d'oxydation ou de pré-oxydation peut être ainsi réalisée sur le matériau semi-conducteur ayant la cinétique d'oxydation la plus lente.

Le procédé suivant l'invention peut permettre ainsi de former, par oxydation, sur un même substrat, des nano-fils à base de matériaux semi-conducteurs différents et ayant des cinétiques d'oxydation différentes voire très différentes.

Selon une possibilité, le premier matériau semi-conducteur peut être du Si, tandis que le deuxième matériau semi-conducteur peut être du Si₁₋ₓGeₓ.

Le premier bloc et le deuxième bloc peuvent être formés à l'étape a) par gravure d'un empilement comportant une alternance de couches à base du premier matériau semi-conducteur et de couches à base du deuxième matériau semi-conducteur.

Plusieurs autres blocs peuvent être formés en même temps que le premier bloc et le deuxième bloc.

Selon une possibilité de mise en oeuvre, lorsque le deuxième matériau semi-conducteur est du Si₁-ₓGeₓ, la proportion en Germanium du deuxième matériau préalablement à l'étape f) et la durée de l'étape f) sont prévus de sorte que, à l'issue de cette étape, ledit autre nano-fil est à base de Ge.

L'oxydation à l'étape f) peut conduire également à la réduction du ou des nano-fils formés à l'étape c).

L'oxydation à l'étape f) est une oxydation sèche. Un tel type d'oxydation peut permettre notamment d'obtenir une bonne sélectivité d'oxydation entre le Si et le Ge.

L'oxydation à l'étape f) peut être conduite entre 850°C et 930°C. Une telle gamme de température permet notamment lorsque le deuxième matériau semi-conducteur est du Si₁₋ₓGeₓ d'obtenir une bonne diffusion du Ge et d'éviter la formation de défauts.

L'épaisseur et la dimension critique respective des barreaux, ainsi que la durée de l'oxydation à l'étape c) et de l'oxydation à l'étape f) peuvent être prévus de sorte qu'à l'issue de l'étape f), le nano-fil et ledit autre nano-fil ont des dimensions critiques égales ou sensiblement égales.

Selon une possibilité de mise en oeuvre, le premier bloc peut être protégé lors du retrait effectué à l'étape b) par ledit masquage à oxydation.

Le masquage à oxydation peut être par exemple à base de nitrure, par exemple du Si₃N₄ ou du SiN.

Selon une possibilité, une couche de relaxation peut être formée entre le masquage à oxydation et lesdits blocs, ladite couche de relaxation étant supprimée préalablement à l'étape d).

La couche de relaxation peut être à base de SiO₂.

Le procédé peut comprendre en outre entre l'étape a) et l'étape b) :
- la formation d'une couche de masquage à oxydation sur lesdits blocs semi-conducteurs,
- la formation d'une couche de protection sur la couche de masquage à oxydation,
- le retrait de ladite couche de protection et de la couche de masquage à oxydation en regard du deuxième bloc, un masquage à oxydation étant conservé en regard du deuxième bloc.

La couche de relaxation et la couche de protection peuvent être formées à base du même matériau, de sorte que le retrait de la couche de protection en regard du premier bloc peut être réalisé en même temps que celui de la couche de relaxation recouvrant le deuxième bloc.

Selon une possibilité de mise en oeuvre du procédé, les barreaux peuvent avoir une section carrée. Cela peut permettre de former des nano-fils de section circulaire.

### BRÈVE DESCRIPTION DES DESSINS

L'invention sera mieux comprise à la lecture de la description détaillée qui va suivre des modes de réalisation de l'invention, fournis à titre illustratif et nullement limitatif, en référence aux dessins annexés, dans lesquels :
- les figures 1A-1O illustrent un procédé suivant l'invention de réalisation d'un dispositif microélectronique doté de nano-fils à base d'un matériau semi-conducteur donné tel que du Si, et de nano-fils à base d'un autre matériau semi-conducteur tel que du Si_{1-y}Ge_{y} co-intégrés sur un même substrat,
- la figure 2 donne une courbe d'épaisseur critique d'une couche de SiGe en fonction de sa concentration en Ge.

### EXPOSÉ DÉTAILLÉ DE MODES DE RÉALISATION PARTICULIERS

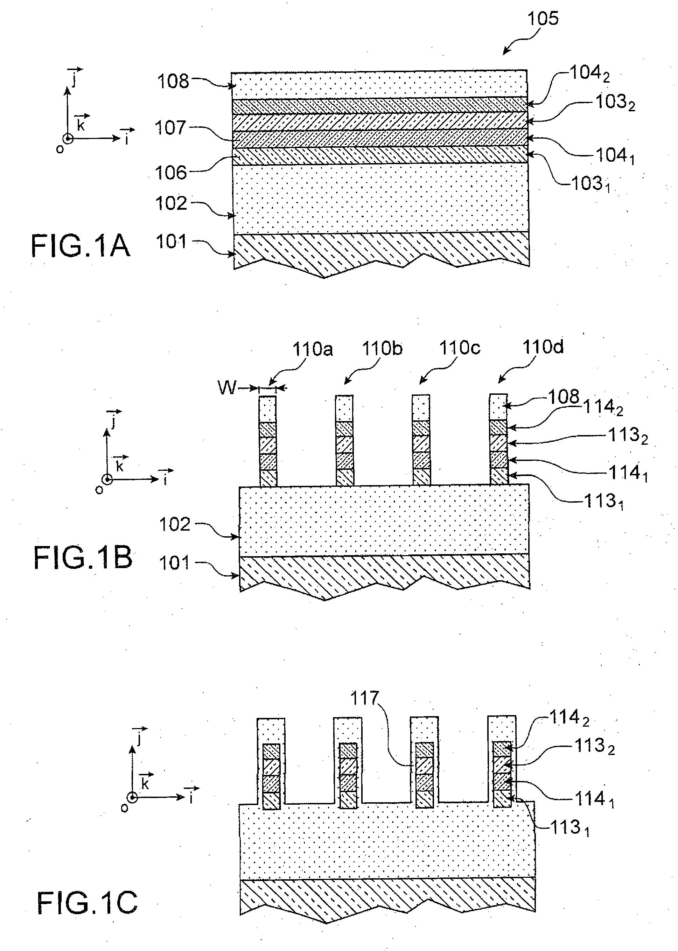

Un exemple de procédé de réalisation d'un dispositif microélectronique doté de nano-fils à base d'un matériau semi-conducteur et de nano-fils à base d'un autre matériau semi-conducteur, co-intégrés sur un même substrat, va à présent être donné en liaison avec les figures 1A-1O.

La première étape de ce procédé illustrée sur la figure 1A, peut consister à réaliser un empilement de couches minces semi-conductrices sur un substrat, qui peut être de type semi-conducteur sur isolant, et comprendre une couche semi-conductrice 101 de support, par exemple à base de silicium, sur laquelle repose une couche isolante 102 par exemple une couche d'oxyde enterré (« burried oxide » selon la terminologie anglo-saxonne) à base de SiO₂, elle-même recouverte d'une couche semi-conductrice 103₁ d'épaisseur généralement plus fine que la couche de support, et que l'on appellera fine couche semi-conductrice 103₁. Dans le cas où le substrat est un substrat SOI (SOI pour « Silicon on Insulator » ou « silicium sur isolant »), cette fine couche semi-conductrice 103₁ peut être par exemple à base de silicium.

Plusieurs autres couches 104₁, 103₂, 104₂, sont réalisées sur la fine couche semi-conductrice 103₁, et forment avec cette dernière un empilement 105 de couches minces semi-conductrices reposant sur la couche isolante 102.

Les couches semi-conductrices 104₁, 103₂, 104₂, peuvent être formées par exemple, par plusieurs épitaxies successives à partir de la fine couche semi-conductrice 103₁.

L'empilement 105 comporte dans cet exemple N=4 couches semi-conductrices 103₁, 104₁, 103₂, 104₂. Le procédé suivant l'invention n'est pas limité à un tel nombre de couches semi-conductrices.

Une alternance de couches notées 103₁, 103₂, à base d'un premier matériau semi-conducteur 106, qui, dans cet exemple, est du Si, et de couches notées 104₁, 104₂, à base d'un deuxième matériau semi-conducteur 107 qui, dans cet exemple, est du Si₁₋ₓGeₓ avec (20 % < x < 30 %) est formé.

Les couches 103₁, 103₂, à base de Si ont des épaisseurs respectives (mesurées dans une direction orthogonale à un plan principal de la couche isolante 102, et parallèle au vecteur *j* du repère [O; *i* ; *j* ; *k* ] défini sur la figure 1A) qui peuvent être par exemple comprises entre 20 et 40 nanomètres.

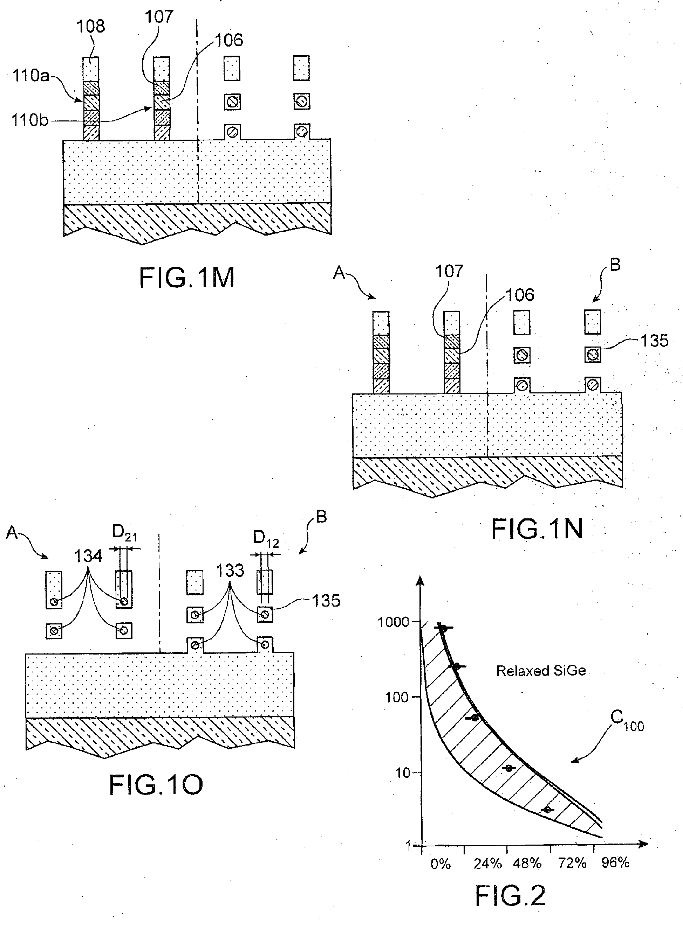

L'épaisseur des couches 104₁, 104₂ à base de Si₁₋ₓGeₓ peut être, quant à elle, choisie inférieure à une épaisseur de relaxation plastique, et que l'on peut déterminer par exemple à l'aide d'une courbe C₁₀₀ telle que donnée sur la figure 2 issue de : J.Apply Phys 83, 171, de 1998, qui donne l'épaisseur critique d'une couche de Si₁₋ₓGeₓ en fonction de la concentration en Ge. Par épaisseur critique on entend l'épaisseur à partir de laquelle le SiGe déposé sur du Si se relaxe plastiquement.

Une fois l'empilement 105 réalisé, on peut effectuer le dépôt d'une couche de masquage dur 108, par exemple à base de SiO₂, d'épaisseur qui peut être par exemple de l'ordre de 20 à 50 nanomètres.

La couche de masque dur 108 peut être formée à l'aide d'un oxyde de silicium de type HTO (HTO pour « High Thermal Oxide »).

Ensuite, on dépose une couche de résine photosensible (non représentée), par exemple à base de polyimide, sur la couche de masque dur 108, et l'on définit dans la couche de résine, par exemple par photolithographie, un masque de résine comportant une pluralité de motifs.

Puis, on effectue une gravure anisotrope de la couche 108 de masque dur protégée par le masque de résine (non représenté), afin de reproduire la pluralité de motifs de ce dernier. La résine est ensuite retirée (figure 1B).

On procède alors à une étape de gravure des couches 103₁, 103₂, 104₁, 104₂, situées sous le masque dur 108, afin de reproduire les motifs de ce dernier dans l'empilement 105. La gravure peut être réalisée par exemple par gravure plasma sèche à base de HBr/O₂/Cl.

On peut former ainsi plusieurs blocs distincts 110a, 110b, 110c, 110d, comprenant chacun une pluralité de barreaux parallélépipédiques également appelées poutres 113₁, 113₂, 114₁, 114₂, empilées.

Sur la figure 1B et les suivantes, ces poutres sont vues en coupe transversale dans un plan qui est parallèle au plan [O;*i*;*j*] défini sur les figures 1A et 1B. Il en est d'ailleurs de même pour les nano-fils dont il sera question par la suite.

Les poutres (comme ces nano-fils) s'étendent suivant une même direction qui est parallèle au substrat. Dans l'exemple, cette même direction est parallèle au plan principal de la couche isolante 102 et elle est définie par le vecteur *k̅* des figures 1A et 1B.

Les poutres 113₁, 113₂, 114₁, 114₂ peuvent avoir une dimension critique W (mesurée dans un plan parallèle au plan principal de la couche isolante 102, c'est à dire parallèle au plan [O;*i̅*;*k̅*] défini sur la figure 1B) comprise entre 20 nm et 50 nm. La dimension critique peut être définie comme la plus petite dimension des poutres hormis leur épaisseur.

Cette dimension critique W ainsi que l'épaisseur e (mesurée dans une direction orthogonale à un plan principal de la couche isolante 102, et parallèle au vecteur *j* du repère [O; *i̅* ; *j̅* ; *k̅* ] défini sur la figure 1B) des poutres de Si₁₋ₓGeₓ et de Si, définissent en partie la taille finale des nano-fils destinés à être réalisés. Pour obtenir des nano-fils de section circulaire, on peut prévoir de réaliser des poutres 113₁, 113₂, 114₁, 114₂ de section carrée, dont le facteur de forme entre leur largeur W et leur épaisseur est égal ou sensiblement égal à 1.

La taille finale qu'aura un nano-fil peut être prévue de sorte à obtenir un compromis entre un bon contrôle électrostatique du nano-fil et une bonne tenue mécanique.

On forme ensuite une couche 117 qui peut être isolante et qui recouvre les flancs des blocs 110a, 110b, 110c, 110d, par exemple à base de SiO₂ (figure 1C).

Puis, on forme une autre couche 119 sur la première couche isolante 117. L'autre couche 119 peut être prévue pour former un masque à oxydation et permettre d'empêcher ou de retarder une oxydation d'un matériau qu'elle est recouvre. La couche de masquage à oxydation 119 peut être isolante et par exemple à base de Si₃N₄ ou de SiN.

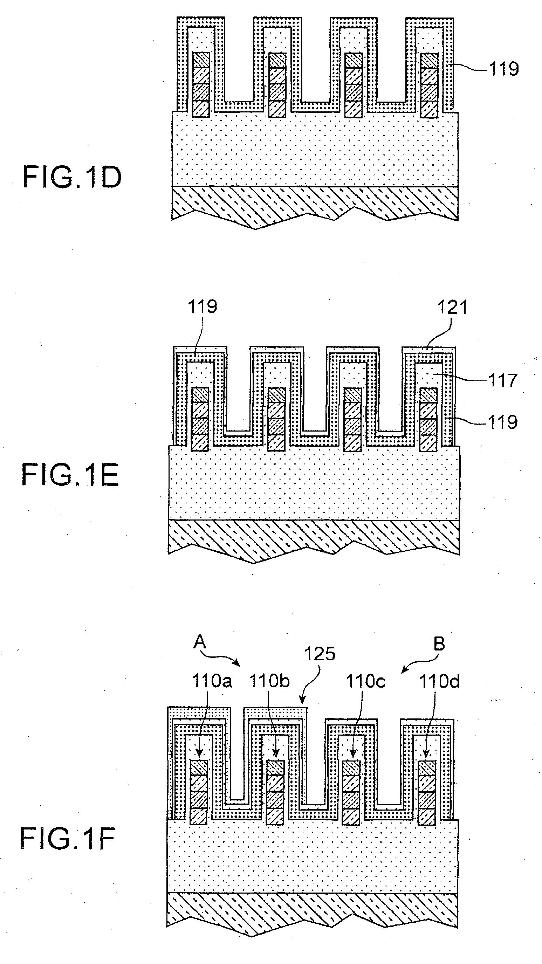

La couche de masquage à oxydation 119 peut avoir une épaisseur comprise par exemple entre 5 et 10 nanomètres d'épaisseur (figure 1D).

Puis, on réalise une troisième couche 121 recouvrant les flancs des blocs 110a, 110b, 110c, 110d. La troisième couche 121 peut faire office de couche de protection de la couche de masquage à oxydation. La couche de protection 121 peut être à base d'un matériau susceptible d'être gravé sélectivement vis à vis de celui de la couche 119 et du même matériau que la couche 117. La couche de protection 121 peut être par exemple à base de SiO₂.

La couche 117 à base de SiO₂ peut être une couche dite « de relaxation », prévue pour réduire la contrainte exercée par la couche de masquage à oxydation 119 vis-à-vis des blocs 110a, 110b, 110c, 110d, en particulier lorsque cette couche 119 est à base de Si₃N₄ (figure 1E).

On défini ensuite plusieurs zones du substrat dans lesquelles vont être réalisées respectivement des nano-fils à base d'un matériau semi-conducteur donné et des nano-fils à base d'un autre matériau semi-conducteur, par exemple une première zone A dans laquelle des nano-fils à base de Si sont destinés à être formés, et une deuxième zone B par exemple dans laquelle des nano-fils à base SiₓGe₁₋ₓ ou de Ge sont destinées à être réalisés.

Ensuite, on forme un masquage de résine 125 dans la première zone A, en regard de certains des blocs 110a, 110b, parmi l'ensemble des blocs gravés de l'empilement 105, la deuxième zone B, et en particulier les autres blocs 110c, 110d, n'étant quant à eux pas recouverts par le masquage 125 (figure 1F).

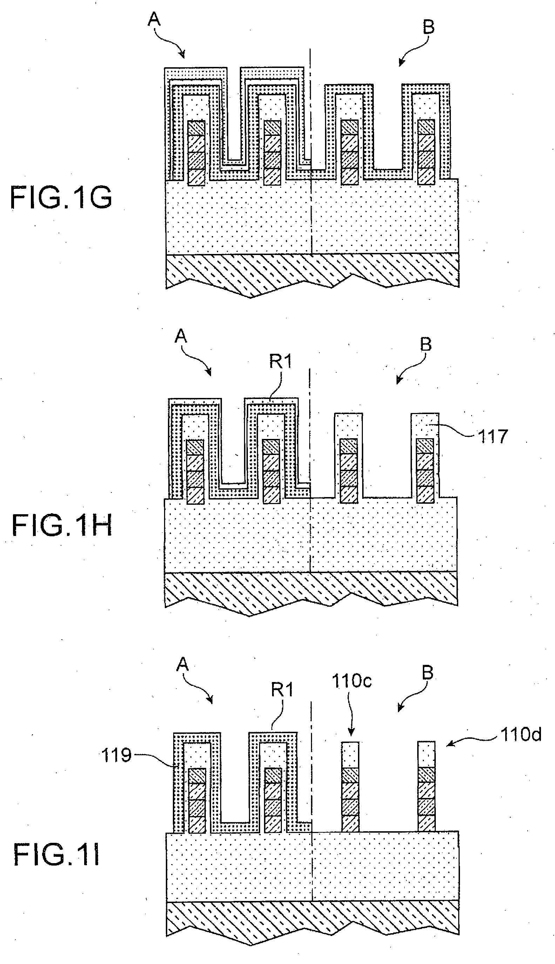

On retire ensuite la couche de protection 121 dans la deuxième zone B, en regard des blocs 110c, 110d par exemple à l'aide d'une gravure sèche plasma anisotrope à base d'une chimie fluoro-carbonée (par exemple : C₄F₈ /CO /Ar) dans un équipement de RIE (Reactive Ion Etching) ou de ME-RIE (Magnetically Enhanced Reactive Ion Etching) équipe d'un système de DFA, ou à l'aide d'une gravure humide isotrope à base de HF (figure 1G).

Puis, on retire le masquage de résine 125 recouvrant la première zone A.

La couche de masquage à oxydation 119 située en regard des blocs 110c, 110d dans la deuxième zone B, peut être ensuite gravée sélectivement, vis-à-vis de la couche de protection 121 située en regard des blocs 110a, 110b dans la première zone A (figure 1H). Cette gravure sélective peut être une gravure humide à base de H₃P0₄ ou une gravure sèche plasma anisotrope à base d'une chimie fluoro-carbonée (par exemple : C₄F₈ /CO /Ar) fait dans un équipement de RIE ou de ME-RIE par exemple lorsque la couche de masquage à oxydation 119 et la couche de protection 121 sont respectivement à base de Si₃N₄ et à base de SiO₂.

Dans la première zone A, la couche de protection 121 recouvre la couche de masquage à oxydation 119, tandis que dans la deuxième zone B, la couche de relaxation 117 est dévoilée.

On effectue ensuite, un retrait d'une partie de la couche de relaxation 117 qui est dévoilée et se situe dans la deuxième zone B et d'une partie de la couche de protection 121 qui est dévoilée et se situe dans la première zone A.

Lorsque la couche de relaxation 117 et la couche de protection 121 sont à base du même matériau, par exemple du SiO₂, ce retrait peut être effectué en même temps, par exemple à l'aide d'une gravure sèche plasma à base de C₄F₈, de CO et d'Ar ou une gravure humide à base de HF.

A l'issue de ce retrait, la couche de masquage à oxydation 119 est dévoilée dans la première zone A, tandis que les empilements de poutres semi-conductrices des blocs 110c, 110d, sont dévoilés (figure 1I).

On retire ensuite les poutres à base du deuxième matériau semi-conducteur 107 dans la deuxième zone B, tandis que les poutres à base du deuxième matériau semi-conducteur 107 dans la première zone A sont protégées de ce procédé de retrait par la couche de masquage à oxydation 119.

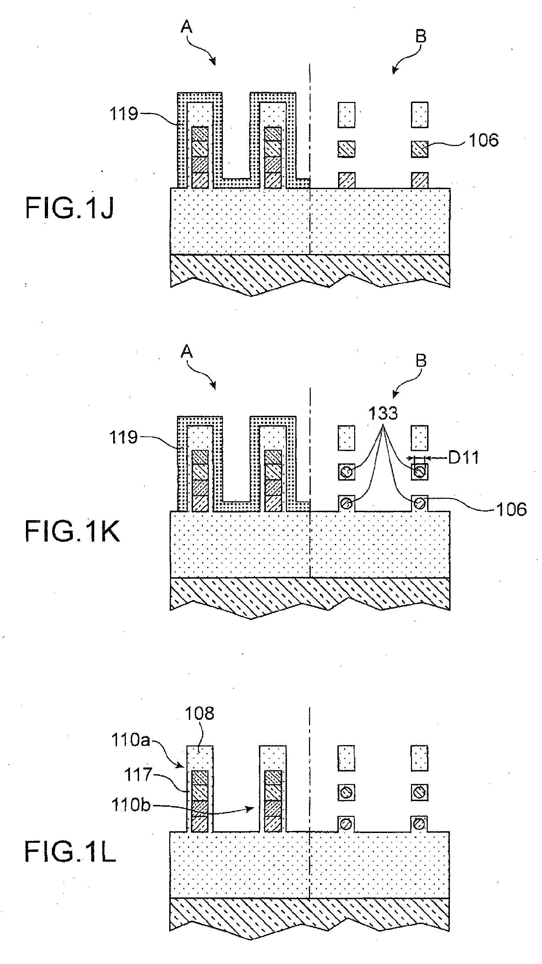

Le retrait peut être effectué par exemple par gravure sélective de Si₁₋ₓGeₓ vis-à-vis du Si, par exemple à l'aide d'une gravure chimique sèche isotrope avec un plasma délocalisé à base de gaz fluoré (CF₄ ou NF₃), ou une gravure humide à base de HF, d'acide acétique CH₃COOH et/ou de HNO₃ ou une gravure à haute température à base de HCl. A l'issue de ce retrait, les poutres à base du premier matériau semi-conducteur 106, ont été libérées dans la deuxième zone B (figure 1J).

On effectue ensuite une première étape d'oxydation du premier matériau semi-conducteur 106 dans la deuxième zone B, tandis que les poutres semi-conductrices dans la première zone A sont protégées par la couche de masquage à oxydation 119. Cette première étape d'oxydation également appelée « pré-oxydation » peut être réalisée par exemple à l'aide d'une oxydation humide afin de limiter le budget thermique.

L'étape d'oxydation a pour effet d'arrondir les poutres de manière à former des nano-fils 133 de section ovoïde ou circulaire à base du premier matériau semi-conducteur 106. Les nano-fils 133 peuvent avoir une dimension critique D11 ou un diamètre D11 qui peut être compris par exemple entre 20 et 40 nanomètres (la dimension critique D11 étant indiquée sur la figure 1K), et ces nano-fils sont entourés d'une épaisseur 135 d'oxyde de silicium, par exemple comprise entre 15 et 25 nanomètres. Pendant cette oxydation, la couche de masquage à oxydation 119 permet d'empêcher ou de retarder une éventuelle oxydation des poutres semi-conductrices situées dans la première zone A.

L'épaisseur 135 d'oxyde prévue autour des nano-poutres peut être ajustée en fonction de la durée de l'étape d'oxydation. Cette épaisseur peut être prévue en fonction de l'épaisseur de la couche de relaxation 117, de sorte que l'épaisseur de la couche de relaxation 117 est inférieure à celle d'oxyde entourant les nano-fils 133. La couche de masquage à oxydation 119, à base de Si₃N₄ est ensuite retirée. Suite à ce retrait, les blocs 110a, 110b, sont recouverts, sur le dessus par le masquage 108, et sur les flancs par la couche de relaxation 117 (figure 1L).

On effectue ensuite un retrait de la couche de relaxation 117. Dans le cas où cette couche de relaxation 117 est à base de SiO₂, ce retrait peut être effectué par exemple à l'aide d'une gravure sèche plasma à base de C₄F₈, de CO et d' Ar ou d' une gravure humide à base de HF, et s'accompagner d'une partie de l'épaisseur d'oxyde formée autour des nano-fils 133.

Le retrait de la couche de relaxation 117 permet de dévoiler les flancs des blocs 110a, 110b situés dans la première zone A et formés chacun d'empilements de poutres semi-conductrices à base du premier matériau semi-conducteur 106 et à base du deuxième matériau semi-conducteur 107 (figure 1M).

On effectue ensuite dans la première zone A un retrait des poutres à base du premier matériau semi-conducteur 106, tout en conservant le deuxième matériau semi-conducteur 107.

Un retrait sélectif de Si vis-à-vis du Si₁-ₓGeₓ peut être réalisé par exemple à l'aide d'une gravure chimique sèche isotrope avec un plasma délocalisé à base de gaz fluoré par exemple à base de CF₄/O₂/N₂, ou NF₃/O₂/N₂, ou NF₃/O₂.

L'épaisseur d'oxyde 135 située autour des nano-fils 133 dans la deuxième zone B, peut quant à elle servir de protection lors de ce retrait (figure 1N) .

On effectue ensuite une oxydation, qui peut être réalisée par exemple par oxydation sèche des nanopoutres à une température comprise entre 850°C et 930°C pour permettre une diffusion suffisante des atomes de Ge dans le fil tout en étant à une température inférieure à celle de fusion du Ge (figure 1O).

Les poutres de Si₁₋ₓGeₓ sont oxydées pendant une durée, qui est choisie en fonction de la dimension critique finale souhaitée pour les nano-fils 133, 134 que l'on souhaite obtenir.

L'oxydation des poutres de Si₁₋ₓGeₓ a tendance à augmenter la proportion en Germanium dans le matériau semi-conducteur restant des poutres à base de Si₁₋ₓGeₓ. La proportion de Germanium souhaitée au final à l'issue de cette étape dépend de la proportion de départ, et de la durée de cette oxydation. L'étape d'oxydation a pour effet d'arrondir les poutres à base de Si₁₋ₓGeₓ de manière à former des nano-fils 134 à base de Si_{1-y}Ge_{y} avec y > x.

Lors de l'oxydation du Si₁₋ₓGeₓ, la concentration en Ge dans le fil augmente tandis que le diamètre du fil diminue. La concentration finale en Ge et la taille du fil dépendent du temps d'oxydation, de la taille initiale de la poutre et de sa concentration en Ge. La cinétique d'oxydation de nano-fils de SiGe peut être de l'ordre de cinq fois plus rapide que celle de couches de SiGe réalisées pleine-plaque.

Par exemple, avec une poutre de Si₁₋ₓGeₓ de section carrée de 22 nm de dimension critique avec une concentration initiale de Ge de 30%, on peut obtenir, après 14 min d'oxydation sèche à 900°C, un nano-fil de section circulaire de dimension critique de 12 nm en Ge.

Après oxydation, des nano-fils 134 à base de Si_{1-y}Ge_{y} ayant une dimension critique D21 ou un diamètre D21 compris par exemple entre 5 et 20 nanomètres (la dimension critique D21 étant indiquée sur la figure 1O), et qui sont entourés d'une épaisseur d'oxyde de silicium, par exemple comprise entre 15 et 25 nanomètres, peuvent être obtenus.

Cette oxydation peut également avoir pour effet de réduire davantage le diamètre ou la dimension critique des nano-fils 133 à base de Si, ces derniers pouvant atteindre une dimension critique D12 ou un diamètre D12 qui peut être compris par exemple 5 et 20 nm (la dimension critique D12 étant indiquée sur la figure 1O).

Pour garantir la sélectivité de l'oxydation du Si par rapport au Ge, une oxydation sèche peut être effectuée.

La température d'oxydation peut être également choisie de manière à être inférieure à la température de fusion du Ge et suffisamment élevée pour permettre la diffusion du Ge dans les nano-fils 134.

Une température d'oxydation Tox comprise entre 850°C et 930°C peut être par exemple mise en oeuvre afin de garantir la sélectivité de l'oxydation.

La durée d'oxydation peut être choisie de sorte que les nano-fils de Si et de Si₁₋ₓGeₓ ont la même taille ou dimension critique.

En connaissant la taille initiale d'une nano-poutre de SiGe et de sa concentration en Ge, on peut calculer le temps d'oxydation nécessaire t₂ pour obtenir un nano-fil de SiGe de taille et de concentration en Ge souhaités.

A partir de ce temps d'oxydation, on peut calculer, par exemple en utilisant des données issues de la publication : Modeling of the oxidation of suspended Silicon Nanowire, P.F. Fazzini, C. Bonafos, A. Hubert, J.-P. Colonna, T. Ernst, M. Respaud, MRS Fall Meeting Boston, 2008*,* le temps d'oxydation t1 nécessaire à ajouter pour obtenir des nano-fils de Si de la même taille que ceux de SiGe en tenant compte du temps d'oxydation supplémentaire t₂, le tout à une température donnée et à un mode d'oxydation (sec ou humide) donné.

Dans un cas par exemple, où l'on souhaite obtenir des nano-fils de Ge de l'ordre de 12 nm de dimension critique obtenus après 14 min d'oxydation sèche à 900°C, pour former des nano-fils de Si de la même taille, une oxydation des nano-fils de Si d'une durée par exemple de l'ordre de 1 h 20 en oxydation sèche à 900°C peut être mise en oeuvre.

Pendant l'oxydation, la concentration en Germanium dans les nano-fils 134 augmente. On peut obtenir des nano-fils avec une proportion en Germanium de l'ordre de 100%, de sorte que des nano-fils 134 à base de Germanium peuvent être obtenus.

Une concentration x initiale Si₁₋ₓGeₓ de Ge dans les nano-fils comprise entre 10 et 40 % peut suffire à obtenir des fils de Ge après une oxydation d'une durée par exemple comprise entre 10 et 20 minutes suivant la taille initiale du nano-fil, qui peut être comprise entre 20 et 50 nm de dimension critique.

Par exemple, si on a une nano-poutre initiale de section carré de 22nm de dimension critique avec une concentration initiale de Ge de 30%, on obtient, après 14 min d'oxydation sèche à 900°C, un nano-fil de section ronde de 12 nm en pur Ge.

On peut par exemple avoir formé des couches 104₁, 104₂ de Si₁₋ₓGeₓ de SiGe dont la concentration en Ge est comprise initialement entre 10 et 40% pour fabriquer les nano-fils à base de Ge, avantageusement supérieure à 30 % afin de limiter la création de défauts dans les nano-fils.

## Revendications

1. Procédé de réalisation d'un dispositif microélectronique comprenant, sur un même substrat, un ou plusieurs nano-fil(s) à base d'un matériau semi-conducteur donné, et un ou plusieurs nano-fil(s) à base d'un autre matériau semi-conducteur, le procédé comprenant les étapes de :
a) formation sur un substrat, d'au moins un premier bloc semi-conducteur (110a) et d'au moins un deuxième bloc semi-conducteur (110c) distinct, le premier bloc et le deuxième bloc comprenant chacun un ou plusieurs barreaux (113₁, 113₂) à base d'un premier matériau semi-conducteur (106) et un ou plusieurs autres barreaux (114₁, 114₂) à base d'un deuxième matériau semi-conducteur (107), lesdits barreaux et autres barreaux s'étendant suivant une même direction qui est parallèle au substrat,
b) retrait dans ledit deuxième bloc semi-conducteur (110c, 110d) du ou des barreaux (114₁, 114₂) à base du deuxième matériau semi-conducteur (107), tandis que les barreaux (113₁, 113₂, 114₁, 114₂) du premier bloc (110a, 110b) sont protégés,
c) oxydation du ou des barreaux (113₁, 113₂) à base du premier semi-conducteur (106) et appartenant au deuxième bloc (110c) de manière à former un ou plusieurs nano-fils (133) entourés d'une épaisseur d'oxyde (135) du premier matériau semi-conducteur, tandis que les barreaux (113₁, 113₂, 114₁, 114₂) du premier bloc sont protégés par un masquage à oxydation (119),
d) retrait du masquage à oxydation (119),
e) retrait du ou des barreaux (113₁, 113₂) à base du premier matériau semi-conducteur (106) dans le premier bloc (110a) tandis que les nano-fils (133) à base du premier matériau semi-conducteur sont protégés,
f) oxydation des barreaux à base du deuxième matériau semi-conducteur de manière à former un ou plusieurs autre(s) nano-fil(s) (134).

2. Procédé selon la revendication 1, le premier bloc (110a) et le deuxième bloc (110c) étant formés à l'étape a) par gravure d'un empilement (105) comportant une alternance de couches (103₁, 103₂) à base du premier matériau semi-conducteur et de couches (104₁, 104₂) à base du deuxième matériau semi-conducteur.

3. Procédé selon l'une des revendications 1 ou 2, le premier matériau semi-conducteur (106) étant du Si, le deuxième matériau semi-conducteur (107) étant du Si₁₋ₓGeₓ, à l'issue de l'étape e) ledit autre nano-fil (134) étant à base de Si_{1-y}Ge_{y}.

4. Procédé selon la revendication 3, dans lequel la durée de l'étape f) est prévue de sorte que, à l'issue de cette étape, ledit autre nano-fil (134) est à base de Ge.

5. Procédé selon l'une des revendications 1 à 4, l'oxydation à l'étape f) conduisant à la réduction du ou des nano-fils (133) formés à l'étape c).

6. Procédé selon l'une des revendications 1 à 5, lequel l'oxydation à l'étape f) est une oxydation sèche.

7. Procédé selon la revendication 6, l'oxydation étant conduite entre 850°C et 930°C.

8. Procédé selon l'une des revendications 1 à 7, dans lequel l'épaisseur et la dimension critique respective des barreaux, ainsi que la durée de l'oxydation à l'étape c) et de l'oxydation à l'étape f) sont prévus de sorte qu'à l'issue de l'étape f), le nano-fil et ledit autre nano-fil ont des dimensions critiques égales ou sensiblement égales.

9. Procédé selon l'une des revendications 1 à 8, le premier bloc (110a, 110b) étant protégé lors du retrait effectué à l'étape b) par ledit masquage à oxydation (119).

10. Procédé selon l'une des revendications 1 à 9, le masquage (119) à oxydation étant à base de Si₃N₄.

11. Procédé selon la revendication 10, une couche (117) de relaxation étant formée entre le masquage à oxydation (119) et lesdits blocs, ladite couche de relaxation étant supprimée préalablement à l'étape d).

12. Procédé selon la revendication 11, la couche (119) de relaxation étant à base de SiO₂.

13. Procédé selon l'une des revendications 1 à 12, comprenant entre l'étape a) et l'étape b) :
- la formation d'une couche de masquage à oxydation (119) sur lesdits blocs,
- la formation d'une couche de protection (121) sur la couche de masquage à oxydation,
- le retrait de ladite couche de protection (121) et de la couche de masquage à oxydation (119) en regard du deuxième bloc, un masquage à oxydation étant conservé en regard du deuxième bloc.

14. Procédé selon la revendication 13 lorsque rattachée à l'une des revendications 11 ou 12, la couche de relaxation et la couche de projection étant formées à base du même matériau, le retrait de la couche de protection (121) en regard du premier bloc étant réalisé en même temps que celui de la couche de relaxation (117) recouvrant le deuxième bloc.

15. Procédé selon l'une des revendications 1 à 14, les barreaux ayant une section carrée.

## Patentansprüche

1. Verfahren zum Herstellen einer mikroelektronischen Vorrichtung, die auf einem gleichen Substrat einen oder mehrere Nanodrähte auf Basis eines gegebenen Halbleitermaterials und einen oder mehrere Nanodrähte auf Basis eines weiteren Halbleitermaterials aufweist, wobei das Verfahren die nachfolgenden Schritte umfasst:
a) Bilden zumindest eines ersten Halbleiterblocks (110a) und zumindest eines separaten zweiten Halbleiterblocks (110c), wobei der erste Block und der zweite Block jeweils einen oder mehrere Stäbe (113₁, 113₂) auf Basis eines ersten Halbleitermaterials (106) und einen oder mehrere andere Stäbe (114₁, 114₂) auf Basis eines zweiten Halbleitermaterials (107) aufweisen, wobei die einen Stäbe und die anderen Stäbe sich in einer gleichen Richtung erstrecken, die parallel zum Substrat verläuft,
b) Entfernen des bzw. der Stäbe (114₁, 114₂) auf Basis des zweiten Halbleitermaterials (107) aus dem zweiten Halbleiterblock (110c, 110d), während die Stäbe (113₁, 113₂, 114₁, 114₂) des ersten Blocks (110a, 110b) geschützt werden,
c) Oxidation des bzw. der dem zweiten Block (110c) zugehörigen Stäbe (113₁, 113₂) auf Basis des ersten Halbleiters (106) derart, dass ein oder mehrere Nanodrähte (133) gebildet werden, die von einer Oxidschicht (135) des ersten Halbleitermaterials umgeben sind, während die Stäbe (113₁, 113₂, 114₁, 114₂) des ersten Blocks von einer Oxidationsmaske (119) geschützt werden,
d) Entfernen der Oxidationsmaske (119),
e) Entfernen des bzw. der Stäbe (113₁, 113₂) auf Basis des ersten Halbleitermaterials (106) aus dem ersten Block (110a), während die Nanodrähte (133) auf Basis des ersten Halbleitermaterials geschützt werden,
f) Oxidation der Stäbe auf Basis des zweiten Halbleitermaterials derart, dass ein oder mehrere weitere Nanodrähte (134) gebildet werden.

2. Verfahren nach Anspruch 1, wobei der erste Block (110a) und der zweite Block (110c) in Schritt a) durch Ätzen einer Stapelung (105) mit einer Wechselfolge von Schichten (103₁, 103₂) auf Basis des ersten Halbleitermaterials und von Schichten (104₁, 104₂) auf Basis des zweiten Halbleitermaterials gebildet werden.

3. Verfahren nach einem der Ansprüche 1 oder 2, wobei das erste Halbleitermaterial (106) Si ist, das zweite Halbleitermaterial (107) Si₁₋ₓGeₓ ist und am Ende von Schritt e) der weitere Nanodraht (134) auf Basis von Si_{1-y}Ge_{y} besteht.

4. Verfahren nach Anspruch 3, wobei die Zeitdauer von Schritt f) so vorgesehen ist, dass am Ende dieses Schrittes der weitere Nanodraht (134) auf Basis von Ge besteht.

5. Verfahren nach einem der Ansprüche 1 bis 4, wobei die Oxidation in Schritt f) zur Verminderung des bzw. der in Schritt c) gebildeten Nanodrähte (133) führt.

6. Verfahren nach einem der Ansprüche 1 bis 5, wobei die Oxidation in Schritt f) eine Trockenoxidation ist.

7. Verfahren nach Anspruch 6, wobei die Oxidation bei zwischen 850°C und 930°C durchgeführt wird.

8. Verfahren nach einem der Ansprüche 1 bis 7, wobei die Dicke und die jeweilige kritische Abmessung der Stäbe sowie die Zeitdauer der Oxidation in Schritt c) und der Oxidation in Schritt f) so vorgesehen sind, dass am Ende von Schritt f) der eine Nanodraht und der andere Nanodraht gleiche bzw. im Wesentlichen gleiche kritische Abmessungen haben.

9. Verfahren nach einem der Ansprüche 1 bis 8, wobei bei der in Schritt b) erfolgenden Entfernung der erste Block (110a, 110b) von der Oxidationsmaske (119) geschützt wird.

10. Verfahren nach einem der Ansprüche 1 bis 9, wobei die Oxidationsmaske (119) auf Basis von Si₃N₄ besteht.

11. Verfahren nach Anspruch 10, wobei zwischen der Oxidationsmaske (119) und den Blöcken eine Relaxationsschicht (117) gebildet wird, wobei die Relaxationsschicht vor dem Schritt d) abgebaut wird.

12. Verfahren nach Anspruch 11, wobei die Relaxationsschicht (119) auf Basis von SiO₂ besteht.

13. Verfahren nach einem der Ansprüche 1 bis 12, umfassend zwischen Schritt a) und Schritt b):
- Bilden einer Oxidationsmaskenschicht (119) auf den Blöcken,
- Bilden einer Schutzschicht (121) auf der Oxidationsmaskenschicht,
- Entfernen der Schutzschicht (121) und der Oxidationsmaskenschicht (119) gegenüber dem zweiten Block, wobei eine Oxidationsmaske gegenüber dem zweiten Block erhalten bleibt.

14. Verfahren nach Anspruch 13 in Kombination mit einem der Ansprüche 11 oder 12, wobei die Relaxationsschicht und die Schutzschicht auf Basis des gleichen Materials ausgebildet werden, wobei das Entfernen der Schutzschicht (121) gegenüber dem ersten Block zeitgleich mit dem Entfernen der den zweiten Block bedeckenden Relaxationsschicht (117) erfolgt.

15. Verfahren nach einem der Ansprüche 1 bis 14, wobei die Stäbe einen quadratischen Querschnitt haben.

## Claims

1. A method for manufacturing a microelectronic device comprising on a same substrate, one or more nanowires based on a given semiconducting material and one or more nanowires based on another semiconducting material, the method comprising the steps of:
a) forming on a substrate at least one first semiconducting block (110a) and at least one distinct second semiconducting block (110c), the first block and the second block each comprising one or more bars (113₁, 113₂) based on a first semiconducting material (106) and one or more other bars (114₁, 114₂) based on a second semiconducting material (107), said bars and other bars extending along a same direction which is parallel to the substrate,
b) removing in said second semiconducting block (110c, 110d), the bar(s) (114₁, 114₂) based on the second semiconducting material (107), while the bars (113₁, 113₂, 114₁, 114₂) of the first block (110a, 110b) are protected,
c) oxidation of the bar(s) (113₁, 113₂) based on the first semiconductor (106) and belonging to the second block (110c) so as to form one or more nanowires (133) surrounded by a thickness (135) of oxide of the first semiconducting material, while the bars (113₁, 113₂, 114₁, 114₂) of the first block are protected by an oxidation mask (119),
d) removing the oxidation mask (119),
e) removing the bar(s) (113₁, 113₂) based on the first semiconducting material (106) in the first block (110a) while the nanowires (133) based on the first semiconducting material are protected,
f) oxidizing the bars based on the second semiconducting material so as to form one or more other nanowires (134).

2. The method according to claim 1, the first block (110a) and the second block (110c) being formed in step a) by etching of a stack (105) including an alternation of layers (103₁, 103₂) based on the first semiconducting material and of layers (104₁, 104₂) based on the second semiconducting material.

3. The method according to any of claims 1 or 2, the first semiconducting material (106) being Si, the second semiconducting material (107) being Si₁₋ₓGeₓ, at the end of step e), said other nanowire (134) being based on Si_{1-y}Ge_{y}.

4. The method according to claim 3, wherein the duration of step f) is provided so that at the end of this step, said other nanowire (134) is based on Ge.

5. The method according to any of claims 1 to 4, the oxidation in step f) leading to the reduction of the nanowire(s) (133) formed in step c).

6. The method according to any of claims 1 to 5, wherein the oxidation in step f) is dry oxidation.

7. The method according to claim 6, the oxidation being conducted between 850°C and 930°C.

8. The method according to any of claims 1 to 7, wherein the thickness and the respective critical dimension of the bars, as well as the duration of the oxidation in step c) and of the oxidation in step f) are provided so that at the end of step f), the nanowire and said other nanowire have equal or substantially equal critical dimensions.

9. The method according to any of claims 1 to 8, the first block (110a, 110b) being protected during the removal carried out in step b) with said oxidation step (119).

10. The method according to any of claims 1 to 9, the oxidation mask (119) being based on Si₃N₄.

11. The method according to claim 10, a relaxation layer (117) being formed between the oxidation mask (119) and said blocks, said relaxation layer being suppressed before step d).

12. The method according to claim 11, the relaxation layer (119) being based on SiO₂.

13. The method according to any of claims 1 to 12, comprising between step a) and step b):
- the formation of an oxidation mask layer (119) on said blocks,
- the formation of a protective layer (121) on the oxidation mask layer,
- the removal of said protective layer (121) and of the oxidation mask layer (119) facing the second block, an oxidation mask being retained facing the second block.

14. The method according to claim 13 when related to any of claims 11 or 12, the relaxation layer and the protective layer being formed based on the same material, the removal of the protective layer (121) facing the first block being accomplished at the same time as that of the relaxation layer (117) covering the second block.

15. The method according to any of claims 1 to 14, the bars having a square section.
